(19) Europäisches Patentamt / European Patent Office / Office européen des brevets

(11) **EP 1 563 607 B1**

(12) **FASCICULE DE BREVET EUROPEEN**

(45) Date de publication et mention
de la délivrance du brevet:
**04.04.2007 Bulletin 2007/14**

(21) Numéro de dépôt: **03796026.7**

(22) Date de dépôt: **19.11.2003**

(51) Int Cl.:
**H03M 1/16** (2006.01)

(86) Numéro de dépôt international:
**PCT/EP2003/050850**

(87) Numéro de publication internationale:
**WO 2004/049577 (10.06.2004 Gazette 2004/24)**

(54) **CONVERTISSEUR ANALOGIQUE/NUMERIQUE POUR HYPERFREQUENCES**

ANALOG-DIGITAL WANDLER FÜR MIKROWELLEN

ANALOG/DIGITAL CONVERTER FOR MICROWAVE FREQUENCIES

(84) Etats contractants désignés:
**AT BE BG CH CY CZ DE DK EE ES FI FR GB GR HU IE IT LI LU MC NL PT RO SE SI SK TR**

(30) Priorité: **22.11.2002 FR 0214681**

(43) Date de publication de la demande:
**17.08.2005 Bulletin 2005/33**

(73) Titulaire: **Thales**
**92200 Neuilly Sur Seine (FR)**

(72) Inventeur: **MAGE, Jean-Claude,**
**THALES Intellectual Property**
**F-94117 Arcueil Cedex (FR)**

(74) Mandataire: **Chaverneff, Vladimir et al**
**Marks & Clerk France**
**31-33 Avenue Aristide Briand**
**94117 Arcueil Cedex (FR)**

(56) Documents cités:
**EP-A- 0 304 894        US-A- 4 315 255**
**US-A- 5 307 063        US-A- 5 400 026**

- **PATENT ABSTRACTS OF JAPAN vol. 013, no. 254 (E-772), 13 juin 1989 (1989-06-13) & JP 01 051681 A (SUMITOMO ELECTRIC IND LTD), 27 février 1989 (1989-02-27)**
- **LEE G S ET AL: "SUPERCONDUCTIVE A/D CONVERTERS" PROCEEDINGS OF THE IEEE, IEEE. NEW YORK, US, vol. 77, no. 8, 1 août 1989 (1989-08-01), pages 1264-1273, XP000071600 ISSN: 0018-9219**

## Description

La présente invention a pour objet un convertisseur analogique/numérique pour hyperfréquences

Pour réaliser un convertisseur analogique/numérique, il faut toujours rechercher un compromis entre rapidité d'acquisition et résolution. Les convertisseurs rapides de type « Flash » sont limités en résolution par la complexité de leurs circuits. En effet, le nombre de comparateurs qu'ils comportent est égal au nombre de points de mesure, soit 256 comparateurs pour un codeur à 8 bits. Par ailleurs, les codeurs à haute résolution sont limités en rapidité du fait de leur principe de fonctionnement (ils comportent généralement un intégrateur à 20 bits fonctionnant à 50Hz) ou du fait de leur fréquence d'horloge (codeurs de type $\Sigma/\Delta$ à 14 bits fonctionnant à 50MHz).

Dans tous ces cas, les performances des circuits semiconducteurs constituant ces convertisseurs sont limitées par :

- la stabilité de leur référence de fréquence,
- la précision de la grandeur de référence utilisée par ces codeurs, cette grandeur étant une tension, un courant ou toute autre grandeur électromagnétique,
- le décalage du zéro des comparateurs (généralement appelé « offset »),
- la complexité de ces circuits,
- la consommation électrique de leurs composants.

Pour ce qui est des convertisseurs classiques de type $\Sigma/\Delta$ ou flash (à base d'interféromètres disposés en puissances de 2) à circuits supraconducteurs, ils sont limités en rapidité, car ils doivent compter $2^n$ points, et le nombre de points par seconde (qui est égal au produit du nombre de points par échantillon multiplié par le nombre d'échantillons arrivant par seconde) correspond à la fréquence de coupure du matériau supraconducteur (de l'ordre de 600 GHz pour le Niobium et 6THz pour les supraconducteurs à haute température critique). Ainsi, un convertisseur en Niobium est limité par la théorie à :

- 300 points (soit environ 8 bits en architecture Flash) pour une fréquence de conversion de 2 GHz,
- 4000 points (soit 12 bits en architecture $\Sigma/\Delta$) pour une fréquence de conversion de 200 MHz.

Ces performances sont sensiblement les mêmes que celles des convertisseurs actuels à semiconducteurs.

Un convertisseur à éléments en matériau supraconducteur à haute température critique est limité à :

- 300 points (soit 8 bits en architecture Flash) pour une fréquence de conversion de 20 GHz,
- 30 000 points (soit 15 bits en architecture $\Sigma/\Delta$) pour une fréquence de conversion de 200 MHz..

De telles performances restent néanmoins insuffisantes pour certaines applications.

JP 01051681 décrit un convertisseur analogique/numérique comportant N boucles supraconductrices sur le trajet de l'onde à convertir ayant la même inductance mais avec des courants critiques différents. Chaque boucle comporte une jonction du type Josephson dont le résultat de la détection de quantité de courant est envoyé directement vers un codeur.

La présente invention a pour objet un convertisseur analogique/numérique qui soit à la fois rapide et à haute résolution, tout en pouvant fonctionner à des fréquences élevées, par exemple dé l'ordre de, ou supérieures à 10 GHz.

Le convertisseur analogique/numérique conforme à l'invention comporte N boucles supraconductrices disposées sur le trajet de l'onde à convertir, ces boucles étant régulièrement espacées entre elles d'une demi-longueur d'onde, chaque boucle comportant une jonction de courant critique reliée par un guide d'onde une cellule de mémoire de sortie, le produit de l'inductance de chaque boucle par son courant critique étant égal à une constante.

La présente invention sera mieux comprise à la lecture de la description détaillée d'un mode de réalisation, pris à titre d'exemple non limitatif et illustré par les dessins annexés, sur lesquels :

- la figure 1 est un schéma d'une boucle supraconductrice et de son guide de sortie, constituant l'un des éléments d'un convertisseur analogique/numérique conforme à l'invention, et
- la figure 2 est le schéma partiel simplifié d'un convertisseur analogique/numérique conforme à l'invention.

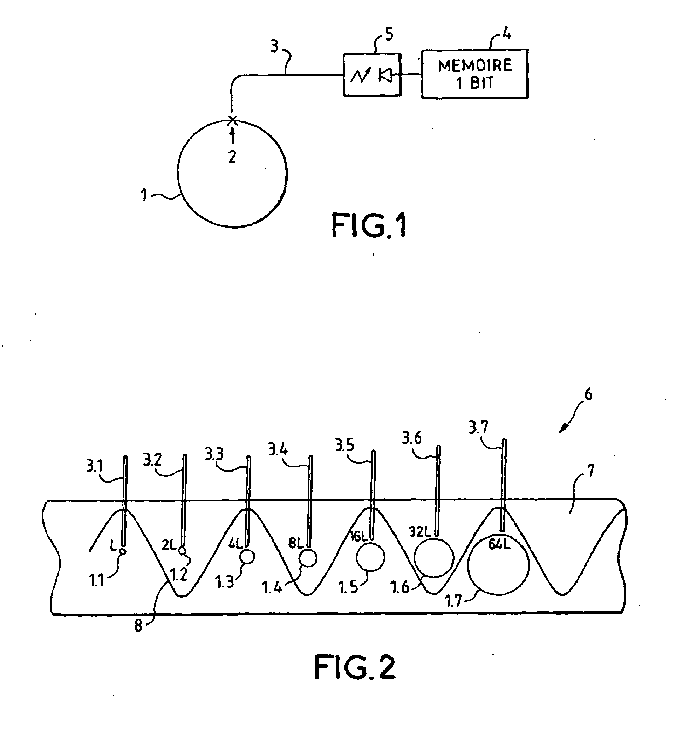

On a représenté en figure 1 un « comparateur élémentaire » qui est un composant élémentaire essentiel du convertisseur analogique/ numérique de l'invention. Ce comparateur élémentaire comporte une boucle supraconductrice 1, de préférence de forme circulaire, dans laquelle est pratiquée une jonction de courant critique 2, un guide d'onde optique 3 et une cellule de mémoire de sortie 4 à un bit, qui est séquencée au rythme d'acquisition désiré. La jonction 2 est une constriction de quelques dizaines de nanomètres ou un « entrefer » pratiqué dans la boucle 1 et dans lequel est formée une couche diélectrique de quelques angströms d'épaisseur. Une des extrémités du guide 3 est disposée presque au contact de la jonction 2, tandis que son autre extrémité est connectée à la mémoire 4. La connexion entre le guide 3 et la mémoire 4 est réalisée, de façon connue un soi, par un capteur photo-électrique 5. Le mémoire 4 fait partie d'un ensemble de cellules de mémoire (ensemble auquel sont reliées les autres boucles, comme décrit ci-dessous en référence à la figure 2). Cet ensemble de cellules de mémoire peut être un circuit intégré de mémoire tel que couramment utilisé dans les micro-ordinateurs.

Du fait que les sorties du convertisseur de l'invention fonctionnent à des fréquences de l'ordre de un ou plusieurs terahertz ($10^{12}$ Hz), le guide d'ondes 3 doit être d'un type particulier pour permettre au mode optique correspondant de s'y établir, et d'être éventuellement amplifié.

Avantageusement, ce guide d'ondes est du type décrit dans l'article de R. KÖHLER et al paru dans la revue NATURE, Volume 417 (6885) du 9 mai 2002, 156-159.

La boucle 1 est disposée dans le champ magnétique du signal à mesurer. Si ce signal se propage dans un guide d'ondes électromagnétiques, la boucle est disposée à l'intérieur de ce guide. Si le signal se propage dans une ligne (par exemple du type « Strip Line »), la boucle est gravée dans cette ligne.

La boucle 1, placée dans ledit champ magnétique, peut absorber un flux magnétique $\Phi_o$ tel que $\Phi = L*i_c$, L étant l'inductance de cette boucle et $i_c$ la valeur du courant critique pouvant circuler dans la boucle 1. La boucle 1 effectue ainsi une comparaison entre le flux magnétique $\Phi_n$ qu'elle reçoit du signal à mesurer et la valeur de référence $\Phi_o$ qu'elle peut absorber. Cette valeur $\Phi_o$ est une référence absolue, grandeur quantique fondamentale (le matériau supraconducteur de la boucle est plongé dans un bain cryogénique à température fixe). Le flux $\Phi_n$ créé par le signal à mesurer étant fonction du courant de ce signal analogique, un ensemble de comparateurs ayant les caractéristiques déterminées décrites ci-dessous permet, après étalonnage, de produire un signal numérique représentant l'amplitude de ce signal analogique, chacun des comparateurs produisant un des bits de ce signal numérique.

Si $\Phi_n < \Phi_o$, la boucle supraconductrice de rang <u>n</u> n'absorbe pas de flux, et une absence de bit, équivalant à un bit $_n$ de valeur « 0 », est mémorisée temporairement dans la boucle.

Si $\Phi_n \geq \Phi_o$, la boucle supraconductrice de rang <u>n</u> absorbe du flux, et la boucle mémorise temporairement un bit$_n$ de valeur « 1 ».

La mise en mémoire d'un bit « 1 » dans la boucle 1 provoque l'émission d'une impulsion de tension, d'une durée de l'ordre d'une ou de plusieurs picosecondes, par la jonction 2. Cette impulsion est captée par le guide 3 et transmise sous forme optique, puis convertie en tension par le dispositif 5 et mémorisée par la mémoire 4.

Dans le cas où il s'agit d'un bit $_n$ = « o », il n'y a pas d'émission d'impulsion de tension par la jonction 2, et la mémoire 4 ne reçoit pas d'impulsion. Elle reste à zéro (si elle l'était précédemment). La remise à zéro se fait automatiquement lorsque le signal repasse par zéro.

Après cette étape de mémorisation, le flux $\delta\phi_n$ sortant du comparateur et transmis au comparateur suivant est : $\delta\Phi_n = \Phi_n - (bit_n.\Phi_o)$.

Cette soustraction est effectuée par l'expulsion du champ résiduel par la boucle supraconductrice 1. Il est à noter que $\delta\Phi_n < \Phi_o$, du fait que, comme décrit ci-dessous, les comparateurs sont disposés, dans le sens de propagation du signal à mesurer, dans l'ordre décroissant de leur poids binaire $2^n$.

Ainsi, le comparateur de la figure 1 permet de réaliser la fonction de convertisseur analogique/numérique à un bit. Le signal à mesurer peut résulter soit de l'échantillonnage d'un signal incident par un échantillonneur-bloqueur piloté par une horloge de référence, soit de la conversion de ce signal incident par mélange de fréquences à l'aide d'un oscillateur local stable oscillant à une fréquence F supérieure à deux fois la fréquence maximale du signal incident. Cette dernière solution est préférée lorsque le signal incident est un signal hyperfréquence, d'une fréquence de l'ordre de 1 GHz à 100 GHz.

Pour réaliser un convertisseur à N bits, on dispose N comparateurs sur le trajet du signal à mesurer, mais ceci ne peut se faire que si, en considérant un comparateur de rang m :

- soit on multiplie le signal de sortie du comparateur de rang m-1 par 2, de façon à obtenir pour l'entrée du comparateur de rang m $\Phi_{m-1} = 2.\delta\Phi_n$, ce qui permet d'utiliser des comparateurs tous identiques les uns aux autres,
- soit on divise la référence en courant du comparateur de rang m+1 par 2, en agissant à la fois sur son inductance L et sur son courant critique $I_c$.

Il faut noter que dans un convertisseur à N bits, le nombre de bits significatifs est fixé par la précision de la réalisation technologique de la boucle (précision de la valeur de son inductance et de son courant critique), de l'horloge de référence ou de l'oscillateur de référence (en particulier sa pureté spectrale), selon que le traitement du signal incident est fait par échantillonnage ou par conversion de fréquence.

Le nombre de comparateurs que comprend un convertisseur à N bits peut être supérieur à N. Ceci permet de ne conserver après la conversion que les bits de poids les plus significatifs. On peut ainsi réaliser un changement de gamme automatique du convertisseur en fonction de la dynamique du signal incident. De façon avantageuse, on peut faire précéder le convertisseur d'un amplificateur à faible bruit, afin d'ajuster sa dynamique à celle du signal incident.

L'horloge (ou l'oscillateur de référence) peut être avantageusement réalisé en technologie supraconductrice afin de réduire sa gigue (ou son bruit de phase).

La chaîne de traitement de signal (non représentée) branchée en aval du convertisseur peut comporter des circuits de correction d'erreurs (ou mettre en oeuvre des codes correcteurs d'erreurs). Ainsi, il est possible de tolérer des précisions moins élevées sur les paramètres L et $I_c$ déterminant le flux $\Phi_o = L.Ic$.

La lecture des mémoires numériques d'un convertisseur s'effectue typiquement à la fréquence F de l'oscillateur local précité. Dans le cas de l'architecture de la figure 2 (dite « architecture en pipe-line »), les bits lus dans les mémoires numériques successives (dans l'ordre de propagation du signal à mesurer) doivent à chaque fois être décalés d'un échantillon pour tenir compte du délai de propagation du signal à mesurer d'une boucle 1 à la suivante. Bien entendu, le traitement numérique effectué sur les bits lus dans les mémoires 4 doit tenir compte de ce décalage. Alternativement, la lecture de ces mémoires 4 peut être accompagnée d'une remise en phase de tous les bits de chaque échantillon du signal à mesurer. Cette remise en phase peut être effectuée à l'intérieur du convertisseur en jouant sur les longueurs des lignes de liaison aux mémoires 4, afin de délivrer tous les bits d'un échantillon au même instant.

La conversion du signal d'entrée par mélange à la fréquence F effectue une remise à zéro automatique des comparateurs et de chaque mémoire de sortie numérique 4 à chaque demi-période du signal de l'oscillateur.

On a représenté en figure 2, de façon simplifiée, l'architecture « pipe-line » 6, qui comporte en fait un grand nombre N (N peut être supérieur à 100) de comparateurs à boucles supraconductrices disposées le long d'une ligne microstrip 7. on n'a représenté que sept de ces boucles, référencées 1.1 à 1.7, avec leurs guides d'ondes optiques respectifs 3.1 à 3.7. Le sens de propagation du signal à mesurer se fait de gauche à droite sur le schéma tel que représenté en figure 2. L'oscillation du signal à mesurer a été symbolisée par une sinusoïde 8. Les boucles supraconductrices sont régulièrement espacées, leur pas d'espacement étant égal à une demi-longueur d'onde du signal à mesurer. Pour le mode de réalisation représenté, l'inductance des boucles supraconductrices successives suit une progression géométrique croissante de raison 2 : leurs inductances sont, pour les boucles 1.1 à 1.7, respectivement égales à L, 2L ,4L, 8L, 16L, 32L, et 64L, tandis que leur courant critique suit une progression géométrique décroissante de raison ½ : $I_c$, $I_c/2$, $I_c/4$ ... $I_c/64$.

Le convertisseur 6 fonctionne de la façon suivante :

Le courant i du signal à mesurer a, au niveau d'une boucle de rang n faisant partie des N boucles supraconductrices 1.1 à 1.N (N pouvant prendre l'une des valeurs 1 à N), la valeur instantanée $i_n$. Ce courant $i_n$ induit dans la boucle 1.n un flux $\Phi_n = L_n.i_n$ ($L_n$ étant la valeur de l'inductance de la boucle 1.n).

$\Phi_{on}$ étant la valeur de seuil du flux que peut absorber la boucle 1.n et qui correspond au courant critique $Ic_n$ de cette boucle, la boucle « compare » $\Phi_{on}$ à $\Phi_n$:

-    si $\Phi_n < \Phi_{on}$, le courant $i_n$ continue à se propager au-delà de la boucle 1.n sans perturbation,
-    si $\Phi_{on} \geq \Phi_{on}$ , un quantum de flux $\Phi_{on}$ est absorbé par la boucle 1.n, et le courant $i_n$ est diminué de

$\Phi_{on}/L_n$. Il en résulte que le courant sortant (en aval de la boucle 1.n) a la valeur $i_n$- $\Phi_{on}/L_n$, et la boucle suivante 1.(n+1) reçoit donc le courant $i_{(n+1)} = i_n$- $\Phi_{on}/L_n$. Ce courant induit dans la boucle 1.(n+1) a pour valeur $L_{(n+1)} = 2L_n$, et son courant critique est égal à $I_{c(n+1)} = I_{cn}/2$, on obtient :

$$\Phi_{(n+1)} = L_{(n+1)} \cdot i_{(n+1)} = 2L_n.i_{(n+1)}$$

Alors, la boucle 1.(n+1) « compare » $\Phi_{o(n+1)}$ à $\Phi_{(n+1)}$ :

-    si $\Phi_{(n+1)} < \Phi_{o(n+1)}$, le courant continue à se propager sans perturbation vers les boucles suivantes,
-    si $\Phi_{(n+1)} \geq \Phi_{o(n+1)}$, un quantum de flux $\Phi_{o(n+1)}$ est absorbé par la boucle 1.(n+1), et le courant du signal à mesurer est diminué de $\Phi_{o(n+1)}/L_{(n+1)}= \Phi_{o(n+1)}/2L_n$. Il en résulte que le courant sortant, juste en aval de la boucle 1.(n+1) est égal à $i_{(n+1)}$- $\Phi_{o(n+1)}/L_{(n+1)}$, et ainsi de suite jusqu'à la dernière boucle 1.N.

La structure 6 est assez simple à réaliser, mais il faut fabriquer très minutieusement les boucles 1.1 à 1.N et leur jonction critique.

En variante de réalisation (non représentée), tous les comparateurs sont identiques entre eux, et un amplificateur de gain 2 est inséré à la sortie de chaque comparateur (sauf du dernier). Le principal avantage d'une telle structure est de conserver un courant du même ordre de grandeur tout au long de la ligne (dans sa partie le long de laquelle sont disposés les N comparateurs). Toutefois, les amplificateurs de gain 2 sont de réalisation délicate, car il faut que ce gain soit très précis, et que leur rapidité de fonctionnement soit élevée.

Selon une autre variante de réalisation du convertisseur de l'invention, celui-ci est associé à un guide d'ondes hyperfréquences. Les boucles supraconductrices sont alors disposées à l'intérieur du guide, perpendiculairement à l'axe du guide (direction de propagation du signal à mesurer). Dans ce cas, également, les comparateurs peuvent soit comporter des boucles supraconductrices à inductance croissant selon une progression géométrique, comme dans le cas de la figure 2, soit comporter des boucles toutes identiques, et être assodés chacun à un amplificateur de gain 2.

Dans tous les modes de réalisation, le premier comparateur rencontré par le signal à mesurer (1.1) fournit le bit de poids le plus élevé du signal numérique, les comparateurs suivants fournissant les bits suivants, dans l'ordre décroissant.

Bien entendu, des moyens, connus en soi, permettent d'étalonner le convertisseur et d'adapter sa gamme de mesure à la dynamique et à la valeur absolue du signal à mesurer.

Ainsi, en mettant en oeuvre la quantification du flux dans un drcuit supraconducteur, il est possible d'obtenir de meilleures performances que celles des convertisseurs connus à semiconducteurs cités en préambule sur les point suivants :

- stabilité de la référence de fréquence : l'oscillateur comporte un résonateur refroidi et possédant un facteur de qualité très élevé,
- prédsion de la référence : elle est liée à la référence absolue du quantum de flux $\Phi_{on}$,
- offset : absence d'offset ou de dérive d'offset liée, grâce à la stabilisation de la température des drcuits supraconducteurs,
- architecture des circuits : elle est très simple (boucles, fibres optiques et mémoires),
- consommation électrique : très faible (circuits de mémorisation seulement).

En outre, les drcuits supraconducteurs autorisent une résolution élevée, bien supérieure à 8 bits grâce au nombre important de boucles pouvant être utilisées. La fréquence de conversion peut être supérieure à 10 GHz. La sensibilité de ce convertisseur est élevée, grâce aux propriétés intrinsèques des jonctions supraconductrices.

## Revendications

1. Convertisseur analogique/numérique pour hyperfréquences comportant N comparateurs à boucles supraconductrices (1.1 à 1.N) disposées sur le trajet de l'onde à convertir, **caractérisé par le fait que** ces boucles sont régulièrement espacées entre elles d'une demi-longueur d'onde, chaque boucle comporte une jonction de courant critique (2) reliée par un guide d'ondes optique (3.1 à 3.n) à une cellule de mémoire de sortie (4), le produit de l'inductance de chaque boucle par son courant critique $(L^*I_c)$ étant égal à une constante.

2. Convertisseur selon la revendication 1, **caractérisé par le fait que**, dans le sens de propagation de l'onde à mesurer, la valeur de l'inductance des boucles respectives suit une progression géométrique croissante de raison 2, tandis que la valeur de leur courant critique suit une progression géométrique décroissante de raison ½.

3. Convertisseur selon la revendication 1, **caractérisé par le fait que** toutes les boucles sont identiques entre elles, la sortie de chaque boucle étant reliée à un multiplieur par 2.

4. Convertisseur selon la revendication 1, **caractérisé par le fait que** le nombre de comparateurs est supérieur au nombre de bits significatifs du convertisseur.

5. Convertisseur selon l'une des revendications précédentes, **caractérisé par le fait que** pour la remise en phase des bits de chaque échantillon du signal à mesurer, il comporte des lignes de longueur variable pour délivrer tous les bits d'un même échantillon au même instant.

## Claims

1. Microwave analogue/digital converter, comprising N comparators consisting of superconducting loops (1.1 to 1.N) placed along the path of the wave to be converted, **characterized in that** these loops are regularly spaced apart by a half-wavelength and each loop has a critical current junction (2) connected via an optical waveguide (3.1 to 3.N) to an output memory cell (4), the product of the inductance of each loop multiplied by its critical current $(Li_c)$ being equal to a constant.

2. Converter according to Claim 1, **characterized in that**, in the direction of propagation of the wave to be measured, the value of the inductance of the respective loops follows an increasing geometric progression of common ratio 2, whereas the value of their critical current follows a decreasing geometric progression of common ratio ½.

3. Converter according to Claim 1, **characterized in that** all the loops are identical to each other, the output of each loop being connected to a times-2 multiplier.

4. Converter according to Claim 1, **characterized in that** the number of comparators is greater than the number of significant bits of the converter.

5. Converter according to one of the preceding claims, **characterized in that**, for phase-resetting the bits of each sample of the signal to be measured, it includes lines of variable length in order to deliver all the bits of the same sample at the same instant.

## Patentansprüche

1. Analog/Digital-Wandler für Hochfrequenzen mit N Komparatoren aus supraleitenden Schleifen (1.1 bis 1.N), die auf dem Weg der umzuwandelnden Welle angeordnet sind, **dadurch gekennzeichnet, dass** diese Schleifen einen regelmäßigen Abstand einer halben Wellenlänge zueinander aufweisen, dass jede Schleife eine Verbindungsstelle kritischen Stroms (2) aufweist, die über einen Lichtwellenleiter (3.1 bis 3.n) mit einer Ausgangs-Speicherzelle (4) verbunden ist, wobei das Produkt aus der Induktanz jeder Schleife und ihrem kritischen Strom $(L^*I_c)$ gleich einer Konstanten ist.

**2.** Wandler nach Anspruch 1, **dadurch gekennzeichnet, dass** in Ausbreitungsrichtung der zu messenden Welle der Wert der Induktanz der jeweiligen Schleife einer zunehmenden geometrischen Progression mit dem Quotient 2 folgt, während der Wert ihres kritischen Stroms einer abnehmenden geometrischen Progression mit einem Quotient ½ folgt.

**3.** Wandler nach Anspruch 1, **dadurch gekennzeichnet, dass** alle Schleifen einander gleich sind, wobei der Ausgang jeder Schleife mit einem Verdoppler verbunden ist.

**4.** Wandler nach Anspruch 1, **dadurch gekennzeichnet, dass** die Anzahl von Komparatoren größer ist als die Anzahl von signifikanten Bits des Wandlers.

**5.** Wandler nach einem der vorhergehenden Ansprüche, **dadurch gekennzeichnet, dass** er zur Phasenregelung der Bits jeder Tastprobe des zu messenden Signals Leitungen unterschiedlicher Länge aufweist, um alle Bits einer Tastprobe im gleichen Zeitpunkt zu liefern.

**FIG.1**

**FIG.2**